(19) **Europäisches Patentamt European Patent Office Office européen des brevets**

(11) **EP 3 678 423 B1**

(12) **EUROPEAN PATENT SPECIFICATION**

(45) Date of publication and mention of the grant of the patent:
**13.12.2023 Bulletin 2023/50**

(21) Application number: **19771344.9**

(22) Date of filing: **22.02.2019**

(51) International Patent Classification (IPC):
*H04W 52/02* (2009.01)    *H03F 1/32* (2006.01)
*H03F 3/193* (2006.01)    *H03F 3/21* (2006.01)
*H03F 3/24* (2006.01)    *H04B 1/04* (2006.01)
*H03F 1/30* (2006.01)

(52) Cooperative Patent Classification (CPC):
**H03F 3/1935; H03F 1/30; H03F 1/32; H03F 1/3241; H03F 3/21; H03F 3/245; H04B 1/0475; H04W 52/02;** H03F 2201/3209; H03F 2201/3224; H04B 2001/0425

(86) International application number:
**PCT/CN2019/075933**

(87) International publication number:
**WO 2019/179280 (26.09.2019 Gazette 2019/39)**

(54) **METHOD AND APPARATUS FOR COMPENSATING FOR LONG-TERM MEMORY EFFECT, AND DEVICE**

VERFAHREN UND VORRICHTUNG ZUR KOMPENSATION VON LANGZEITSPEICHEREFFEKTEN UND VORRICHTUNG

PROCÉDÉ ET APPAREIL DE COMPENSATION D'EFFET DE MÉMOIRE À LONG TERME, ET DISPOSITIF ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.03.2018 CN 201810244204**

(43) Date of publication of application:
**08.07.2020 Bulletin 2020/28**

(73) Proprietor: **ZTE Corporation Shenzhen, Guangdong 518057 (CN)**

(72) Inventors:
- **NING, Dongfang Shenzhen, Guangdong 518057 (CN)**
- **DAI, Zhengjian Shenzhen, Guangdong 518057 (CN)**
- **ZHANG, Zhe Shenzhen, Guangdong 518057 (CN)**
- **YUAN, Jing Shenzhen, Guangdong 518057 (CN)**
- **ZHAO, Gang Shenzhen, Guangdong 518057 (CN)**
- **ZHANG, Zuofeng Shenzhen, Guangdong 518057 (CN)**
- **WANG, Lei Shenzhen, Guangdong 518057 (CN)**

(74) Representative: **Canzler & Bergmeier Patentanwälte Partnerschaft mbB Despag-Straße 6 85055 Ingolstadt (DE)**

(56) References cited:
CN-A- 1 874 176     CN-A- 101 483 627
CN-A- 101 977 426     CN-A- 102 348 264
CN-A- 104 283 826     US-B1- 9 866 269

- **PATRICK ROBLIN ET AL: "New Trends for the Nonlinear Measurement and Modeling of High-Power RF Transistors and Amplifiers With Memory Effects", IEEE TRANSACTIONS ON MICROWAVE THEORY AND TECHNIQUES, PLENUM, USA, vol. 60, no. 6, 2 June 2012 (2012-06-02), pages 1964-1978, XP011445310, ISSN: 0018-9480, DOI: 10.1109/TMTT.2012.2193140**

**Description**

## TECHNICAL FIELD

The present disclosure relates to the field of communication technologies, in particular, to a method, a device and an apparatus for compensating for long-term memory effect.

## BACKGROUND

Gallium nitride (GaN) power amplifiers are widely used in base stations in the field of communications due to their advantages of high efficiency, high power density, and wide bandwidth; however, the GaN power amplifier has a special electronic capture characteristic due to the device material, that is, under impulse of a periodic pulse signal, quiescent current in the GaN power amplifier is slowly reduced. It generally takes the characteristic several milliseconds to become stabilized, and the characteristic will make nonlinear distortion of the power amplifier show a kind of long-term memory effect. The long-term memory effect on the GaN power amplifier may cause the distortion to show a millisecond-level characteristic, whereas the conventional digital pre-distortion technologies can only correct nanosecond-level distortion, instead of millisecond-level distortion of the power amplifier, thereby reducing a radio frequency index of the base station. The disclosures of US9866269B1 and XP011445310 with the title "New Trends for the Nonlinear Measurement and Modeling of High-Power RF Transistors and Amplifiers With Memory Effects" address correction of memory effects for GaN-based power amplifiers.

## SUMMARY

The invention is set out in the appended set of claims. To achieve the above objects of the disclosure, in an embodiment of the disclosure, there is further provided a computer program product including a computer program stored on a non-transient computer readable storage medium, the computer program including program instructions which, when executed by a computer, the methods of the above aspects are implemented by the computer.

## BRIEF DESCRIPTION OF THE DRAWINGS

FIG. 1 is a flowchart illustrating a first embodiment of the method for compensating for long-term memory effect of the disclosure;

FIG. 2 is a flowchart illustrating a second embodiment of the method for compensating for long-term memory effect of the disclosure;

FIG. 3 is a schematic diagram of determining a current work status indication signal in the second embodiment of the method for compensating for long-term memory effect of the disclosure;

FIG. 4 is a schematic diagram of obtaining a multidimensional nonlinear function value in the second embodiment of the method for compensating for long-term memory effect of the disclosure;

FIG. 5 is a schematic diagram of outputting the compensated baseband signal in the second embodiment of the method for compensating for long-term memory effect of the disclosure;

FIG. 6 is a schematic diagram illustrating the method for compensating for long-term memory effect of the disclosure applied to a power amplifier of a 4G base station;

FIG. 7 is a schematic structural diagram of an embodiment of a device for compensating for long-term memory effect of the disclosure; and

FIG. 8 is a schematic structural diagram of an embodiment of an apparatus for compensating for long-term memory effect of the disclosure.

## DETAILED DESCRIPTION

The technical solutions in the embodiments of the present disclosure will be described clearly and completely below with reference to the accompanying drawings in the embodiments of the present disclosure.

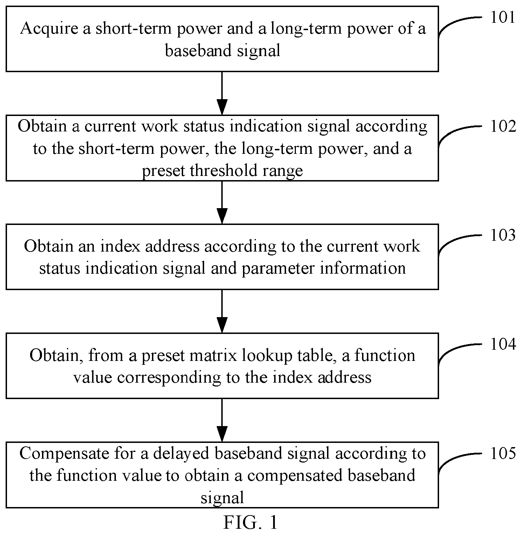

FIG. 1 is a flowchart illustrating a first embodiment of the method for compensating for long-term memory effect of the disclosure. As shown in FIG. 1, the method for compensating for long-term memory effect provided in the embodiment of the present disclosure may be applied to a device for compensating for long-term memory effect (hereinafter referred to as "device"), and may include the following steps S101 to S105.

At step 101, a short-term power and a long-term power of a baseband signal are acquired.

The device acquires a short-term power and a long-term power of the baseband signal in real time; wherein the baseband signal may be a baseband signal in a Mobile Communications (MC) technology which includes, but is not limited to, 2nd-Generation MC technology (2G), 3rd-Generation MC technology (3G), 4th-Generation MC technology (4G), 5th-Generation MC technology (5G), and future MC technologies.

At step 102, a current work status indication signal is obtained according to the short-term power, the long-term power and a preset threshold range.

The device obtains a current work status indication signal according to the acquired short-term power and long-term power and a preset threshold range; wherein the preset threshold range may be set based on actual needs, and thus is not limited herein.

At step 103, an index address is obtained according to the current work status indication signal and parameter information.

The device obtains an index address according to the current work status indication signal and parameter information.

At step 104, a multidimensional nonlinear function value corresponding to the index address is obtained from a preset matrix lookup table.

The device obtains a multidimensional nonlinear function value corresponding to the index address in a preset matrix lookup table.

At step 105, a delayed baseband signal is compensated for according to the multidimensional nonlinear function value to obtain a compensated baseband signal.

The device compensates for the delayed baseband signal according to the multidimensional nonlinear function value obtained in step 104, and finally obtains a compensated baseband signal.

The method of compensating for long-term memory effect provided in the embodiment of the present disclosure, by acquiring a short-term power and a long-term power of a baseband signal; obtaining a current work status indication signal according to the short-term power, the long-term power, and a preset threshold range; obtaining an index address according to the current work status indication signal and parameter information; obtaining, from a preset matrix lookup table, a multidimensional nonlinear function value corresponding to the index address; and compensating for a delayed baseband signal according to the multidimensional nonlinear function value to obtain a compensated baseband signal, can quickly correct electronic capture effect of an amplifier, that is, implement real-time compensation for the long-term memory effect of the power amplifier, and can correct millisecond-level distortion, so as to overcome the problem that a conventional pre-distortion technique cannot compensate for millisecond-level distortion, and improve the radio frequency index of a base station.

To better embody the purpose of the present disclosure, examples are further illustrated on the basis of the above embodiment.

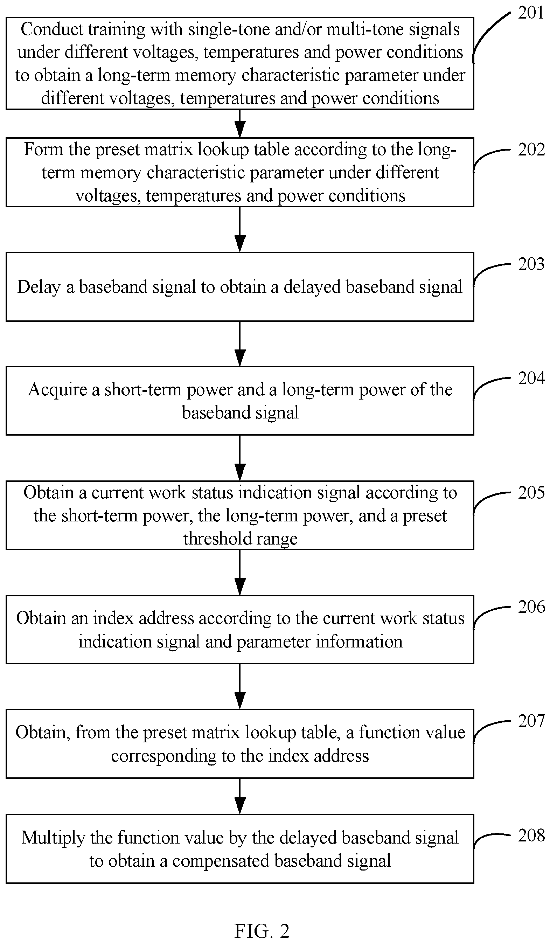

FIG. 2 is a flowchart illustrating a second embodiment of the method for compensating for long-term memory effect of the disclosure. As shown in FIG. 2, the method for compensating for long-term memory effect provided in the embodiment of the present disclosure is applied to a device for compensating for long-term memory effect on a GaN power amplifier (hereinafter "the device"), and the method may include the following steps S201 to S208.

At step 201, training is conducted with single-tone and/or multi-tone signals under different voltages, temperatures and power conditions to obtain a long-term memory characteristic parameter under different voltages, temperatures and power conditions.

The device conducts training with single-tone and/or multi-tone signals for the GaN power amplifier under different voltages, temperatures and power conditions to obtain a long-term memory characteristic parameter under different voltages, temperatures and power conditions, the parameter being a multidimensional function.

The voltages, temperatures and power conditions herein may be set based on actual needs, and thus are not limited herein.

At step 202, the preset matrix lookup table is formed according to the long-term memory characteristic parameter under different voltages, temperatures and power conditions.

The device forms the preset matrix lookup table from the long-term memory characteristic parameter under different voltages, temperatures and power conditions obtained in step 201.

At step 203, a baseband signal is delayed to obtain a delayed baseband signal.

The device delays an input baseband signal to obtain a delayed baseband signal. The specific delay parameter herein may be set based on actual needs, and thus is not limited herein.

At step 204, a short-term power and a long-term power of the baseband signal are acquired.

The device acquires a short-term power and a long-term power of the baseband signal; wherein the short-term power and the long-term power of the baseband signal may be acquired by, but not limited to, the following method, and the short-term power and the long-term power of the baseband signal are acquired according to the following formulas:

$$PowS(n) = \begin{cases} \frac{1}{N}\sum_{n-N+1}^{n}|x(i)|^2 \\ \lambda_S PowS(n) + (1-\lambda_S)|x(n)|^2 \end{cases}$$

or,

$$PowL(n) = \begin{cases} \frac{1}{M}\sum_{n-M+1}^{n}|x(i)|^2 \\ \lambda_L PowL(n) + (1-\lambda_L)|x(n)|^2 \end{cases}$$

or, where *PowS* (*n*) is the short-term power, *PowL* (*n*) is the long-term power, *n* is a sampling number of the baseband signal, *x(i)* is the baseband signal, *N* is a short-term window length, *M* is a long-term window length, and $\lambda_S$ and $\lambda_L$ are memory factors.

At step 205, a current work status indication signal is obtained according to the short-term power, the long-term power and a preset threshold range.

Specifically, the device first subtracts the long-term power from the short-term power to obtain a difference value, and then determines and obtains a current work status indication signal according to a relationship between the difference value and the preset threshold range; wherein the preset threshold range is formed by a first preset threshold value and a second preset threshold value, and the first preset threshold value is greater than the second preset threshold value. The specific preset threshold value may be set based on actual needs and thus is not repeated here.

When the difference value is greater than the first preset threshold value, it is determined that the current work status indication signal is a Charge status indication signal; when the difference value is smaller than the second preset threshold value, it is determined that the current work status indication signal is a Discharge status indication signal; and when the difference value is smaller than or equal to the first preset threshold value and greater than or equal to the second preset threshold value, it is determined that the current work status indication signal is a Hold status indication signal.

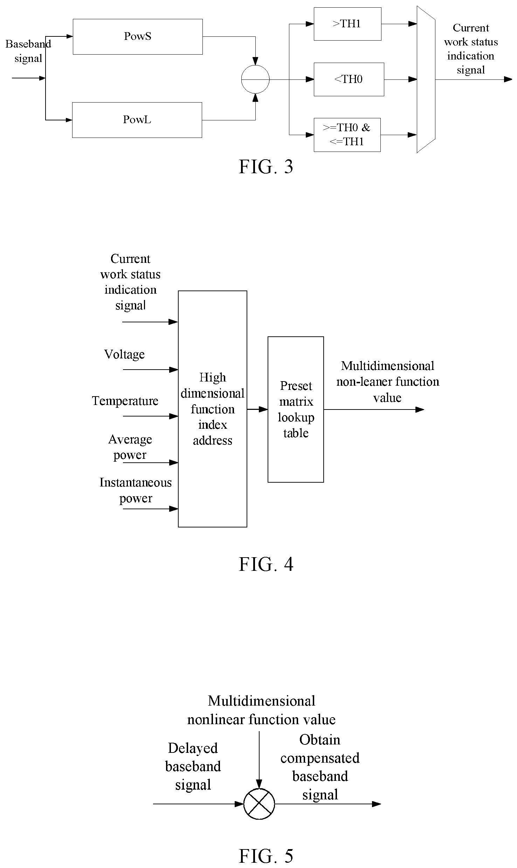

FIG. 3 is a schematic diagram of determining a current work status indication signal in the second embodiment of the method for compensating for long-term memory effect of the disclosure. As shown in FIG. 3, the following formula may be used for comparison and judgment to obtain the current work status indication signal.

$$Sta = \begin{cases} ChargeStatus & if\ (PowS - PowL) > TH1 \\ DisChargeStatus & if\ (PowS - PowL) < TH0 \\ HoldStatus & if\ TH0 \leq (PowS - PowL) \leq TH1 \end{cases}$$

where *Sta* represents the current work status indication signal, *ChargeStatus* represents the Charge status indication signal, *DisChargeStatus* represents the Discharge status indication signal, *HoldStatus* represents the Hold status indication signal, *TH*1 represents the first preset threshold value, and *TH*0 represents the second preset threshold value.

At step 206, an index address is obtained according to the current work status indication signal and parameter information.

The device obtains a high dimensional function index address according to the current work status indication signal and parameter information determined in step 205; wherein the parameter information includes: a voltage, a temperature, an average power, and an instantaneous power.

At step 207, a multidimensional nonlinear function value corresponding to the index address is obtained from the preset matrix lookup table.

The device finds a multidimensional nonlinear function value corresponding to the index address in step 206 in the preset matrix lookup table, where the multidimensional nonlinear function value is a multidimensional nonlinear function value.

FIG. 4 is a schematic diagram of obtaining a multidimensional nonlinear function value in the second embodiment of the method for compensating for long-term memory effect of the disclosure. As shown in FIG. 4, the device obtains a high dimensional function index address according to the current work status indication signal, the voltage, the temperature, the average power and the instantaneous power; and then, finds a multidimensional nonlinear function value corresponding to the high dimensional function index address in the preset matrix lookup table.

At step 208, the multidimensional nonlinear function value is multiplied by the delayed baseband signal to obtain a compensated baseband signal.

FIG. 5 is a schematic diagram of outputting the compensated baseband signal in the second embodiment of the method for compensating for long-term memory effect of the disclosure. As shown in FIG. 5, the device multiplies the multidimensional nonlinear function value by the delayed baseband signal to obtain a compensated baseband signal. For example, the compensated baseband signal is calculated according to the formula $y(n) = x(n)* f(n)$ , where $y(n)$ is the compensated baseband signal, $x'(n)$ is the delayed baseband signal, and $f(n)$ is an output value of the multidimensional function lookup table.

The method of compensating for long-term memory effect provided in the embodiment of the disclosure, by conducting training with single-tone and/or multi-tone signals under different voltages, temperatures and power conditions to obtain a long-term memory characteristic parameter under different voltages, temperatures and power conditions; forming the preset matrix lookup table according to the long-term memory characteristic parameter under different voltages, temperatures and power conditions; delaying the baseband signal to obtain a delayed baseband signal; acquiring a short-term power and a long-term power of the baseband signal; obtaining a current work status indication signal according to the short-term power, the long-term power, and a preset threshold range; obtaining an index address according to the current work status indication signal and parameter information; obtaining, from the preset matrix lookup table, a multidimensional nonlinear function value corresponding to the index address; and multiplying the multidimensional nonlinear function value by the delayed baseband signal to obtain a compensated baseband signal, can quickly correct electronic capture effect of an amplifier, that is, implement real-time compensation for the long-term memory effect of the power amplifier, and can correct millisecond-level distortion, so as to overcome the problem that a conventional pre-distortion technique cannot compensate for millisecond-level distortion, and improve the radio frequency index of a base station, especially the adjacent channel power leakage ratio and the vector error magnitude.

To better embody the purpose of the present disclosure, a scenario embodiment is further illustrated on the basis of the above embodiments.

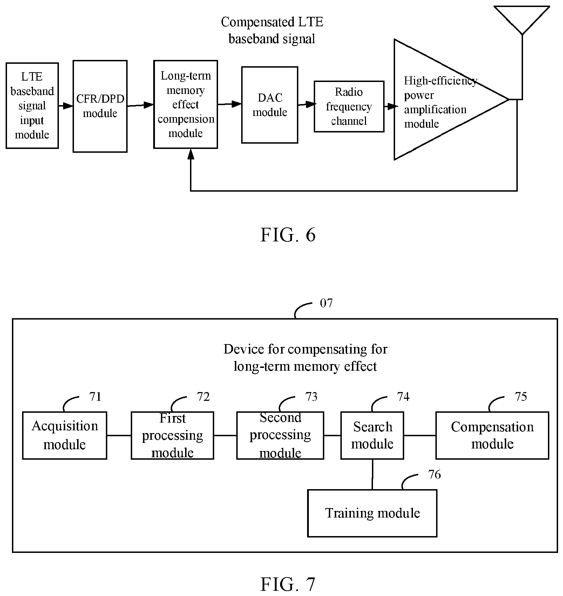

FIG. 6 is a schematic diagram illustrating the method for compensating for long-term memory effect of the disclosure applied to a power amplifier of a 4G base station. As shown in FIG. 6, a power amplifier of the 4G base station mainly includes: a Long Term Evolution (LTE) baseband signal input module, a Crest Factor Reduction (CFR)/Digital Pre-Distortion (DPD) module, a long-term memory effect compensation module, a Digital to analog converter (DAC) module, a radio frequency channel, and a high-efficiency power amplification module, which are connected in turn.

The LTE baseband signal input module generates an LTE baseband signal. The CFR/DPD module is used for short-term nonlinear distortion compensation for the power amplifier. The long-term memory effect compensation module is configured to perform long-term memory effect compensation for the power amplifier on the LTE baseband signal, more details of which may be referred to the description of the foregoing embodiments and are not repeated herein. The DAC module is configured to convert the compensated LTE baseband signal from a digitalized signal to an analog signal. The radio frequency channel and the high-efficiency power amplification module are configured to send the analog compensated LTE baseband signal to an antenna after power amplification to emit in an electromagnetic wave form. Finally, long-term memory effect compensation for the power amplifier is implemented on the LTE baseband signal.

FIG. 7 is a schematic structural diagram of an embodiment of a device for compensating for long-term memory effect of the disclosure. As shown in FIG. 7, the device 07 for compensating for long-term memory effect provided in the embodiment of the disclosure includes: an acquisition module 71 configured to acquire a short-term power and a long-term power of a baseband signal; a first processing module 72 configured to obtain a current work status indication signal according to the short-term power, the long-term power, and a preset threshold range; a second processing module 73 configured to obtain an index address according to the current work status indication signal and parameter information; a search module 74 configured to obtain, from a preset matrix lookup table, a multidimensional nonlinear function value corresponding to the index address; and a compensation module 75 configured to compensate for a delayed baseband signal according to the multidimensional nonlinear function value to obtain a compensated baseband signal.

Further, the device further includes:
a training module 76 configured to conduct training with single-tone and/or multi-tone signals under different voltages, temperatures and power conditions to obtain a long-term memory characteristic parameter under different voltages, temperatures and power conditions, the long-term memory characteristic parameter under different voltages, temperatures and power conditions being a multidimensional function; and form the preset matrix lookup table according to the long-term memory characteristic parameter under different voltages, temperatures and power conditions.

Further, the first processing module 72 is specifically configured to subtract the long-term power from the short-term power to obtain a difference value; determine, when the difference value is greater than a first preset threshold value, that the current work status indication signal is a Charge status indication signal; determine, when the difference value is smaller than a second preset threshold value, that the current work status indication signal is a Discharge status indication signal; and determine, when the difference value is smaller than or equal to the first preset threshold value and greater than or equal to the second preset threshold value, that the current work status indication signal is a Hold status indication signal; wherein the preset threshold range is formed by the first preset threshold value and the second preset threshold value, and the first preset threshold value is greater than the second preset threshold value.

Further, the compensation module 75 is specifically configured to multiply the multidimensional nonlinear function value by the delayed baseband signal to obtain the compensated baseband signal.

Further, the acquisition module 71 is specifically configured to respectively acquire the short-term power and the long-term power of the baseband signal according to the following formulas:

$$\text{PowS}(n) = \begin{cases} \frac{1}{N} \sum_{n-N+1}^{n} |x(i)|^2 \\ \lambda_S \text{PowS}(n) + (1 - \lambda_S)|x(n)|^2 \end{cases}$$

or,

$$\text{PowL}(n) = \begin{cases} \frac{1}{M} \sum_{n-M+1}^{n} |x(i)|^2 \\ \lambda_L \text{PowL}(n) + (1 - \lambda_L)|x(n)|^2 \end{cases}$$

or, where $PowS(n)$ is the short-term power, $PowL(n)$ is the long-term power, $n$ is a sampling number of the baseband signal, $x(i)$ is the baseband signal, $N$ is a short-term window length, $M$ is a long-term window length, and $\lambda_S$ and $\lambda_L$ are memory factors.

Further, the parameter information includes: a voltage, a temperature, an average power, and an instantaneous power.

The device of this embodiment may be configured to implement the technical solutions of the above-described method embodiments, and the implementation principles and technical effects thereof are similar, which are not repeated herein.

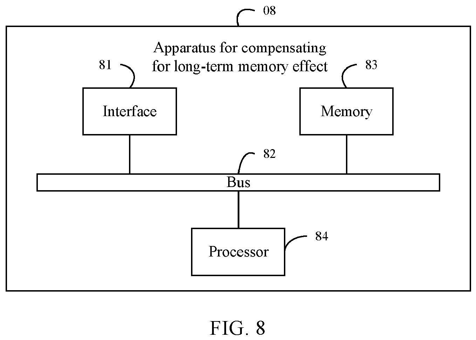

FIG. 8 is a schematic structural diagram of an embodiment of an apparatus for compensating for long-term memory effect of the disclosure. As shown in FIG. 8, the apparatus 08 for compensating for long-term memory effect provided in the embodiment of the disclosure includes: an interface 81, a bus 82, a memory 83, and a processor 84, the interface 81, the memory 83, and the processor 84 are connected through the bus 82, the memory 83 is configured to store an executable program, and the processor 84 is configured to run the executable program to implement the steps of acquiring a short-term power and a long-term power of a baseband signal; obtaining a current work status indication signal according to the short-term power, the long-term power, and a preset threshold range; obtaining an index address according to the current work status indication signal and parameter information; obtaining, from a preset matrix lookup table, a multidimensional nonlinear function value corresponding to the index address; and compensating for a delayed baseband signal according to the multidimensional nonlinear function value to obtain a compensated baseband signal.

Further, the processor 84 is further configured to execute the executable program to implement the steps of conducting training with single-tone and/or multi-tone signals under different voltages, temperatures and power conditions to obtain a long-term memory characteristic parameter under different voltages, temperatures and power conditions, the long-term memory characteristic parameter under different voltages, temperatures and power conditions being a multidimensional function; and forming the preset matrix lookup table according to the long-term memory characteristic parameter under different voltages, temperatures and power conditions.

Further, the processor 84 is configured to execute the executable program to implement the steps of: subtracting the long-term power from the short-term power to obtain a difference value; determining, when the difference value is greater than a first preset threshold value, that the current work status indication signal is a Charge status indication signal; determining, when the difference value is smaller than a second preset threshold value, that the current work status indication signal is a Discharge status indication signal; and determining, when the difference value is smaller than or equal to the first preset threshold value and greater than or equal to the second preset threshold value, that the current work status indication signal is a Hold status indication signal; wherein the preset threshold range is formed by the first preset threshold value and the second preset threshold value, and the first preset threshold value is greater than the second preset threshold value.

Further, the processor 84 is configured to execute the executable program to implement the step of multiplying the multidimensional nonlinear function value by the delayed baseband signal to obtain the compensated baseband signal.

Further, the processor 84 is configured to execute the executable program to implement the step of acquire the short-term power and the long-term power of the baseband signal, respectively, according to the following formulas:

$$\text{PowS}(n) = \begin{cases} \frac{1}{N} \sum_{n-N+1}^{n} |x(i)|^2 \\ \lambda_S \text{PowS}(n) + (1 - \lambda_S)|x(n)|^2 \end{cases}$$

or,

$$PowL(n) = \begin{cases} \frac{1}{M}\sum_{n-M+1}^{n}|x(i)|^2 \\ \lambda_L PowL(n) + (1-\lambda_L)|x(n)|^2 \end{cases}$$

or, where *PowS(n)* is the short-term power, *PowL(n)* is the long-term power, *n* is a sampling number of the baseband signal, *x(i)* is the baseband signal, *N* is a short-term window length, *M* is a long-term window length, and $\lambda_S$ and $\lambda_L$ are memory factors.

Further, the parameter information includes: a voltage, a temperature, an average power, and an instantaneous power.

As shown in FIG. 8, the various components in the apparatus 08 for compensating for long-term memory effect are coupled together via the bus 82. It will be appreciated that the bus 82 is configured to enable connective communication between these components. The bus 82 includes, in addition to a data bus, a power bus, a control bus, and a status signal bus. However, for clarity of illustration, the various buses are indicated in FIG. 8 as the bus 82.

The interface 81 may include a display, a keyboard, a mouse, a trackball, a click wheel, a key, a button, a touch pad, or a touch screen, or the like.

It will be appreciated that the memory 83 may include a volatile memory or a non-volatile memory or both. The non-volatile memory may be a Read-Only Memory (ROM), a Programmable Read-Only Memory (PROM), an Erasable Programmable Read-Only Memory (EPROM), an Electrically Erasable Programmable Read-Only Memory (EEPROM), a ferromagnetic random access memory (FRAM), a Flash Memory, a magnetic surface memory, an optical disk, or a Compact Disc Read-Only Memory (CD-ROM); the magnetic surface memory may be a disk or tape memory. The volatile memory may be a Random Access Memory (RAM) used as an external cache. By way of example but not limitation, many forms of RAMs are available, such as a Static Random Access Memory (SRAM), a Synchronous Static Random Access Memory (SSRAM), a Dynamic Random Access Memory (DRAM), a Synchronous Dynamic Random Access Memory (SDRAM), a Double Data Rate Synchronous Dynamic Random Access Memory (DDRSDRAM), an Enhanced Synchronous Dynamic Random Access Memory (ESDRAM), a SyncLink Dynamic Random Access Memory (SLDRAM), a Direct Rambus Random Access Memory (DRRAM). The memory 83 described in the embodiment of the disclosure is intended to include, but not limited to, these and any other suitable types of memories.

The memory 83 in the embodiment of the present disclosure is configured to store various types of data to support operations of the apparatus 08 for compensating for long-term memory effect, and examples of the data include: any computer program, such as an operating system, an application, or the like, to be operated on the apparatus 08 for compensating for long-term memory effect. The operating system includes various system programs, such as a framework layer, a core library layer, a driving layer, so as to implement various basic services and process hardware-based tasks. The application may include various applications such as a Media Player, a Browser, etc,. so as to implement various application services, and a program for implementing the methods in the embodiments of the disclosure may be included in the application.

The method disclosed in the embodiments of the disclosure may be applied to or implemented by the processor 84. The processor 84 may be an integrated circuit chip capable of signal processing. In implementation, the steps of the above methods may be implemented by an integrated logic circuit in hardware or instructions in software in the processor 84. The processor 84 may be a general purpose processor, a Digital Signal Processor (DSP), or other programmable logic devices, discrete gate or transistor logic devices, discrete hardware components, etc.; and the processor 84 may implement or perform the methods, steps, and logic blocks disclosed in the embodiments of the present disclosure. The general purpose processor may be a microprocessor or any conventional processor or the like. The steps of the method disclosed in the embodiments of the present disclosure may be directly implemented by a hardware decoding processor, or implemented by a combination of hardware and software modules in the decoding processor. The software module may be located in a storage medium in the memory 83, and the processor 84 reads information from the memory 83 and completes the steps of the above methods in combination with hardware thereof.

In an exemplary embodiment, the apparatus 08 for compensating for long-term memory effect may be implemented by at least one Application Specific Integrated Circuit (ASIC), DSP, Programmable Logic Device (PLD), Complex Programmable Logic Device (CPLD), Field-Programmable Gate Array (FPGA), general purpose processor, controller, Micro Controller Units (MCU), Microprocessor, or other electronic components to perform the above methods.

The apparatus of this embodiment may be configured to implement the technical solutions of the above-described method embodiments, and the implementation principles and technical effects thereof are similar, which are not repeated herein.

In an embodiment of the present disclosure, there is further provided a computer readable storage medium, which may be an FRAM, a ROM, a PROM, an EPROM, an EEPROM, a Flash Memory, a magnetic surface memory, an optical disk, or a CD-ROM or other memories, or maybe various apparatuses including one of the above memories or their combination. The computer readable storage medium has a program stored thereon, the program is executable by the processor to implement the steps according to the independent claim 1.

**Claims**

1. A method of compensating for long-term memory effect on a GaN power amplifier, the method comprising delaying (S203) a baseband signal to obtain a delayed baseband signal, the method **characterised in that** the method comprises:
   acquiring (S 101) a short-term power and a long-term power of the baseband signal;

   obtaining (S102) a current work status indication signal according to the short-term power, the long-term power, and a preset threshold range;
   obtaining (S103) an index address, which is a a high dimensional function index address, according to the current work status indication signal and parameter information comprising a voltage, a temperature, an average power and an instantaneous power,
   obtaining (S104), from a preset matrix lookup table, a multidimensional nonlinear function value corresponding to the index address; and
   multipling (105) the multidimensional nonlinear function value by the delayed baseband signal to obtain a compensated baseband signal;
   wherein the current work status indication signal is obtained according to:

$$Sta = \begin{cases} ChargeStatus & if\ (PowS - PowL) > TH1 \\ DisChargeStatus & if\ (PowS - PowL) < TH0 \\ HoldStatus & if\ TH0 \le (PowS - PowL) \le TH1 \end{cases}$$

   where $Sta$ represents the current work status indication signal, $ChargeStatus$ represents the Charge status indication signal, $DisChargeStatus$ represents the Discharge status indication signal, $HoldStatus$ represents the Hold status indication signal, $TH1$ represents the first preset threshold value, and $TH0$ represents the second preset threshold value;
   wherein before acquiring the short-term power and the long-term power of the baseband signal, the method further comprises:

   conducting (S201) training for the GaN power amplifier with single-tone and/or multi-tone signals under different voltages, temperatures and power conditions to obtain a long-term memory characteristic parameter under different voltages, temperatures and power conditions, the long-term memory characteristic parameter under different voltages, temperatures and power conditions being a multidimensional function; and
   forming (S202) the preset matrix lookup table according to the long-term memory characteristic parameter under different voltages, temperatures and power conditions;
   wherein the step of acquiring the short-term power and the long-term power of the baseband signal comprises:

   acquiring (S204) the short-term power and the long-term power of the baseband signal, respectively, according to the following formulas,

$$PowS(n) = \begin{cases} \frac{1}{N}\sum_{n-N+1}^{n}|x(i)|^2 \\ \lambda_S PowS(n-1) + (1-\lambda_S)|x(n)|^2 \end{cases}$$

   or,

$$PowL(n) = \begin{cases} \frac{1}{M}\sum_{n-M+1}^{n}|x(i)|^2 \\ \lambda_L PowL(n-1) + (1-\lambda_L)|x(n)|^2 \end{cases}$$

or,

where $PowS(n)$ is the short-term power, $PowL(n)$ is the long-term power, $n$ is a sampling number of the baseband signal, $x(i)$ is the baseband signal, $N$ is a short-term window length, $M$ is a long-term window length, and $\lambda_S$ and $\lambda_L$ are memory factors.

2. A device of compensating for long-term memory effect on a GaN power amplifier, **characterized in that** the device comprises:

an acquisition module (71) configured to acquire a short-term power and a long-term power of a baseband signal;
a first processing module (72) configured to obtain a current work status indication signal according to the short-term power, the long-term power, and a preset threshold range;
a second processing module (73) configured to obtain an index address, which is a a high dimensional function index address, according to the current work status indication signal and parameter information comprising a voltage, a temperature, an average power and an instantaneous power,
a search module (74) configured to obtain, from a preset matrix lookup table, a multidimensional nonlinear function value corresponding to the index address; and
a compensation module (75) configured to multiply the multidimensional nonlinear function value by a delayed baseband signal to obtain a compensated baseband signal;
wherein the current work status indication signal is obtained according to:

$$Sta = \begin{cases} ChargeStatus & if \ (PowS - PowL) > TH1 \\ DisChargeStatus & if \ (PowS - PowL) < TH0 \\ HoldStatus & if \ TH0 \le (PowS - PowL) \le TH1 \end{cases}$$

where $Sta$ represents the current work status indication signal, $ChargeStatus$ represents the Charge status indication signal, $DisChargeStatus$ represents the Discharge status indication signal, $HoldStatus$ represents the Hold status indication signal, $TH1$ represents the first preset threshold value, and $TH0$ represents the second preset threshold value;
wherein the device further comprises:

a training module (76) configured to conduct training for the GaN power amplifier with single-tone and/or multi-tone signals under different voltages, temperatures and power conditions to obtain a long-term memory characteristic parameter under different voltages, temperatures and power conditions, the long-term memory characteristic parameter under different voltages, temperatures and power conditions being a multidimensional function; and form the preset matrix lookup table according to the long-term memory characteristic parameter under different voltages, temperatures and power conditions;
wherein the acquisition module (71) is configured to acquire the short-term power and the long-term power of the baseband signal, respectively, according to the following formulas,

$$PowS(n) = \begin{cases} \frac{1}{N} \sum_{n-N+1}^{n} |x(i)|^2 \\ \lambda_S PowS(n-1) + (1-\lambda_S)|x(n)|^2 \end{cases}$$

or,

$$PowL(n) = \begin{cases} \frac{1}{M} \sum_{n-M+1}^{n} |x(i)|^2 \\ \lambda_L PowL(n-1) + (1-\lambda_L)|x(n)|^2 \end{cases}$$

or,
where $PowS(n)$ is the short-term power, $PowL(n)$ is the long-term power, $n$ is a sampling number of the baseband signal, $x(i)$ is the baseband signal, $N$ is a short-term window length, $M$ is a long-term window length, and $\lambda_S$ and $\lambda_L$ are memory factors.

3. An apparatus for compensating for long-term memory effect of a GaN power amplifier, wherein the apparatus comprises: an interface, a bus, a memory, and a processor, the interface, the memory, and the processor are connected through the bus, the memory is configured to store an executable program comprising instructions to cause the processor to execute the steps of the method of claim 1.

4. A computer readable storage medium having stored thereon the executable program of claim 3.


**Patentansprüche**

1. Verfahren zur Kompensation des Langzeitspeichereffekts bei einem GaN-Leistungsverstärker, wobei das Verfahren Folgendes umfasst:
Verzögern (S203) eines Basisbandsignals, um ein verzögertes Basisbandsignal zu erhalten, wobei das Verfahren **dadurch gekennzeichnet ist, dass** das Verfahren umfasst:

Erfassen (S101) einer Kurzzeitleistung und einer Langzeitleistung des Basisbandsignals ;
Erhalten (S102) eines Signals zur Anzeige des aktuellen Arbeitsstatus in Abhängigkeit von der Kurzzeitleistung, der Langzeitleistung und einem voreingestellten Schwellenwertbereich ;
Erhalten (S103) einer Indexadresse, bei der es sich um eine hochdimensionale Funktionsindexadresse handelt, entsprechend dem Signal zur Anzeige des aktuellen Arbeitsstatus und der Parameterinformation , die eine Spannung, eine Temperatur, eine durchschnittliche Leistung und eine momentane Leistung umfasst,
Erhalten (S104) eines mehrdimensionalen nichtlinearen Funktionswertes, der der Indexadresse entspricht, aus einer voreingestellten Matrixnachschlagetabelle; und
Multiplikation (105) des mehrdimensionalen nichtlinearen Funktionswertes mit dem verzögerten Basisbandsignal, um ein kompensiertes Basisbandsignal zu erhalten;
wobei das Signal zur Anzeige des aktuellen Arbeitsstatus gemäß erhalten wird:

$$Sta = \begin{cases} ChargeStatus & if\ (PowS - PowL) > TH1 \\ DisChargeStatus & if\ (PowS - PowL) < TH0 \\ HoldStatus & if\ TH0 \leq (PowS - PowL) \leq TH1 \end{cases}$$

wobei *Sta* das Signal zur Anzeige des aktuellen Arbeitsstatus, *ChargeStatus* das Signal zur Anzeige des Ladestatus, *DisChargeStatus* das Signal zur Anzeige des Entladestatus, *HoldStatus* das Signal zur Anzeige des Haltestatus, *TH*1 den ersten voreingestellten Schwellenwert und *TH*0 den zweiten voreingestellten Schwellenwert darstellen;
wobei das Verfahren vor dem Erfassen der Kurzzeitleistung und der Langzeitleistung des Basisbandsignals weiterhin umfasst:

Durchführen (S201) eines Trainings für den GaN-Leistungsverstärker mit Ein-Ton-Signalen und/oder Mehr-Ton-Signalen unter verschiedenen Spannungen, Temperaturen und Leistungsbedingungen, um einen Langzeitspeicher-Charakteristik-Parameter unter verschiedenen Spannungen, Temperaturen und Leistungsbedingungen zu erhalten, wobei der Langzeitspeicher-Charakteristik-Parameter unter verschiedenen Spannungen, Temperaturen und Leistungsbedingungen eine mehrdimensionale Funktion ist; und
Bilden (S202) der voreingestellten Matrixnachschlagetabelle gemäß dem Langzeitspeicher-Charakteristik-Parameter unter verschiedenen Spannungen, Temperaturen und Leistungsbedingungen ;
wobei der Schritt des Erfassens der Kurzzeitleistung und der Langzeitleistung des Basisbandsignals umfasst:

Erfassen (S204) der Kurzzeitleistung und der Langzeitleistung des Basisbandsignals gemäß den folgenden Formeln,

$$PowS(n) = \begin{cases} \frac{1}{N}\sum_{n-N+1}^{n}|x(i)|^2 & or \\ \lambda_S PowS(n-1) + (1-\lambda_S)|x(n)|^2 \end{cases},$$

$$PowL(n) = \begin{cases} \frac{1}{M}\sum_{n-M+1}^{n}|x(i)|^2 & or \\ \lambda_L PowL(n-1) + (1-\lambda_L)|x(n)|^2 \end{cases},$$

wobei *PowS(n)* die Kurzzeitleistung, *PowL(n)* die Langzeitleistung, *n* eine Abtastzahl des Basisbandsignals, *x(i)* das Basisbandsignal, *N* eine Kurzzeitfensterlänge, *M* eine Langzeitfensterlänge ist und $\lambda_S$ und $\lambda_L$ Speicherfaktoren sind.

2. Vorrichtung zur Kompensation des Langzeitspeichereffekts bei einem GaN-Leistungsverstärker, **dadurch gekennzeichnet, dass** die Vorrichtung Folgendes umfasst:

ein Erfassungsmodul (71), das zur Erfassung einer Kurzzeitleistung und einer Langzeitleistung eines Basisbandsignals konfiguriert ist;

ein erstes Verarbeitungsmodul (72), das konfiguriert ist, dass es ein Signal zur Anzeige des aktuellen Arbeitsstatus gemäß der Kurzzeitleistung, der Langzeitleistung und einem voreingestellten Schwellenwertbereich erhält;

ein zweites Verarbeitungsmodul (73), das konfiguriert ist, dass es eine Indexadresse, bei der es sich um eine hochdimensionale Funktionsindexadresse handelt, gemäß dem Signal zur Anzeige des aktuellen Arbeitsstatus und Parameterinformationen, die eine Spannung, eine Temperatur, eine durchschnittliche Leistung und eine momentane Leistung umfassen, erhält,

ein Suchmodul (74), das konfiguriert ist, dass es aus einer voreingestellten Matrixnachschlagetabelle einen mehrdimensionalen nichtlinearen Funktionswert erhält, der der Indexadresse entspricht; und

ein Kompensationsmodul (75), das konfiguriert ist, dass es den mehrdimensionalen nichtlinearen Funktionswert mit einem verzögerten Basisbandsignal multipliziert, um ein kompensiertes Basisbandsignal zu erhalten;

wobei das Signal zur Anzeige des aktuellen Arbeitsstatus gemäß erhalten wird:

$$Sta = \begin{cases} ChargeStatus & if\ (PowS - PowL) > TH1 \\ DisChargeStatus & if\ (PowS - PowL) < TH0 \\ HoldStatus & if\ TH0 \leq (PowS - PowL) \leq TH1 \end{cases}$$

wobei *Sta* das Signal zur Anzeige des aktuellen Arbeitsstatus, *ChargeStatus* das Signal zur Anzeige des Ladestatus, *DisChargeStatus* das Signal zur Anzeige des Entladestatus, *HoldStatus* das Signal zur Anzeige des Haltestatus, *TH*1 den ersten voreingestellten Schwellenwert und *TH*0 den zweiten voreingestellten Schwellenwert darstellen;

wobei die Vorrichtung weiterhin umfasst:

ein Trainingsmodul (76), das konfiguriert ist, dass es ein Training für den GaN-Leistungsverstärker mit Ein-Ton-Signalen und/oder Mehr-Ton-Signalen unter verschiedenen Spannungen, Temperaturen und Leistungsbedingungen durchführt, um einen Langzeitspeicher-Charakteristik-Parameter unter verschiedenen Spannungen, Temperaturen und Leistungsbedingungen zu erhalten, wobei der Langzeitspeicher-Charakteristik-Parameter unter verschiedenen Spannungen, Temperaturen und Leistungsbedingungen eine mehrdimensionale Funktion ist; und die voreingestellte Matrixnachschlagetabelle entsprechend dem Langzeitspeicher-Charakteristik-Parameter unter verschiedenen Spannungen, Temperaturen und Leistungsbedingungen bildet;

wobei das Erfassungsmodul (71) konfiguriert ist, dass es die Kurzzeitleistung bzw. die Langzeitleistung des Basisbandsignals gemäß den folgenden Formeln erfasst,

$$PowS(n) = \begin{cases} \frac{1}{N}\sum_{n-N+1}^{n}|x(i)|^2 & or \\ \lambda_S PowS(n-1) + (1-\lambda_S)|x(n)|^2 \end{cases},$$

$$PowL(n) = \begin{cases} \frac{1}{M}\sum_{n-M+1}^{n}|x(i)|^2 & or \\ \lambda_L PowL(n-1) + (1-\lambda_L)|x(n)|^2 \end{cases},$$

wobei *PowS(n)* die Kurzzeitleistung, *PowL(n)* die Langzeitleistung, *n* eine Abtastzahl des Basisbandsignals, *x(i)* das Basisbandsignal, *N* eine Kurzzeitfensterlänge, *M* eine Langzeitfensterlänge ist und $\lambda_S$ und $\lambda_L$ Speicherfaktoren sind.

3. Vorrichtung zum Kompensieren des Langzeitspeichereffekts eines GaN-Leistungsverstärkers, wobei die Vorrichtung umfasst: eine Schnittstelle, einen Bus, einen Speicher und einen Prozessor, wobei die Schnittstelle, der Speicher und der Prozessor über den Bus verbunden sind, der Speicher konfiguriert ist, dass er ein ausführbares Programm speichert, das Befehle umfasst, um den Prozessor zu veranlassen, die Schritte des Verfahrens nach Anspruch 1 auszuführen.

4. Computerlesbares Speichermedium, auf dem das ausführbare Programm nach Anspruch 3 gespeichert ist.


**Revendications**

1. Procédé de compensation de l'effet mémoire à long terme sur un amplificateur de puissance GaN, le procédé comprenant :
   retarder (S203) un signal en bande de base pour obtenir un signal en bande de base retardé , le procédé **caractérisé en ce que** le procédé comprend :

   acquérir (S101) une puissance à court terme et une puissance à long terme du signal en bande de base ;
   obtenir (S102) un signal d'indication de l'état actuel du travail en fonction de la puissance à court terme, de la puissance à long terme et d'une plage de seuils prédéfinie ;
   obtenir (S 103) une adresse d'index, qui est une adresse d'index de fonction à haute dimension, en fonction du signal d'indication de l'état actuel du travail et des informations de paramètres comprenant un voltage, une température, une puissance moyenne et une puissance instantanée,
   obtenir (S 104), à partir d'une table de recherche matricielle prédéfinie, une valeur de fonction non linéaire multidimensionnelle correspondant à l'adresse d'indexation ; et
   multiplier (105) la valeur de la fonction non linéaire multidimensionnelle par le signal en bande de base retardé pour obtenir un signal en bande de base compensé ;
   dans lequel le signal d'indication de l'état actuel du travail est obtenu selon :

$$Sta = \begin{cases} ChargeStatus & if\ (PowS - PowL) > TH1 \\ DisChargeStatus & if\ (PowS - PowL) < TH0 \\ HoldStatus & if\ \ TH0 \leq (PowS - PowL) \leq TH1 \end{cases}$$

   où *Sta* représente le signal d'indication de l'état actuel du travail, *ChargeStatus* représente le signal d'indication de l'état de charge, *DisChargeStatus* représente le signal d'indication de l'état de décharge, *HoldStatus* représente le signal d'indication de l'état de maintien, *TH*1 représente la première valeur seuil prédéfinie, et *TH*0 représente la deuxième valeur seuil prédéfinie ;
   dans lequel, avant d'acquérir la puissance à court terme et la puissance à long terme du signal en bande de base, le procédé comprend en outre :

   effectuer (S201) un entraînement pour l'amplificateur de puissance GaN avec des signaux monotons et/ou multitons sous différentes tensions, températures et conditions de puissance pour obtenir un paramètre caractéristique de la mémoire à long terme sous différents voltages, températures et conditions de puissance, le paramètre caractéristique de la mémoire à long terme sous différents voltages, températures et conditions de puissance étant une fonction multidimensionnelle ; et
   former (S202) la table de recherche matricielle prédéfinie en fonction du paramètre caractéristique de la mémoire à long terme sous différents voltages, températures et conditions d'alimentation ;
   dans lequel l'étape d' acquérir la puissance à court terme et de la puissance à long terme du signal en bande de base comprend :

   acquérir (S204) la puissance à court terme et la puissance à long terme du signal en bande de base, respectivement, selon les formules suivantes,

$$PowS(n) = \begin{cases} \frac{1}{N}\sum_{n-N+1}^{n}|x(i)|^2 & or \\ \lambda_S PowS(n-1) + (1-\lambda_S)|x(n)|^2 \end{cases},$$

$$\text{PowL(n)} = \begin{cases} \frac{1}{M}\sum_{n-M+1}^{n}|x(i)|^2 & \text{or} \\ \lambda_L \text{PowL}(n-1) + (1-\lambda_L)|x(n)|^2 \end{cases},$$

où *PowS*(*n*) est la puissance à court terme, *PowL*(*n*) est la puissance à long terme, *n* est un numéro d'échantillonnage du signal en bande de base, *x*(*i*) est le signal en bande de base, *N* est une longueur de fenêtre à court terme, *M* est une longueur de fenêtre à long terme, et $\lambda_S$ et $\lambda_L$ sont des facteurs de mémoire.

2. Dispositif de compensation de l'effet de mémoire àlong terme sur un amplificateur de puissance GaN, **caractérisé par le fait que** le dispositif comprend:

un module d'acquisition (71) configuré pour acquérir une puissance à court terme et une puissance à long terme d'un signal en bande de base ;
un premier module de traitement (72) configuré pour obtenir un signal d'indication de l'état actuel du travail en fonction de la puissance à court terme, de la puissance à long terme et d'une plage de seuils prédéfinie ;
un deuxième module de traitement (73) configuré pour obtenir une adresse d'index, qui est une adresse d'index de fonction à haute dimension, en fonction du signal d'indication de l'état actuel du travail et des informations de paramètre comprenant un voltage, une température, une puissance moyenne et une puissance instantanée,
un module de recherche (74) configuré pour obtenir, à partir d'une table de recherche matricielle prédéfinie, une valeur de fonction non linéaire multidimensionnelle correspondant à l'adresse d'index ; et
un module de compensation (75) configuré pour multiplier la valeur de la fonction non linéaire multidimensionnelle par un signal en bande de base retardé afin d'obtenir un signal en bande de base compensé ;
dans lequel le signal d'indication de l'état actuel du travail est obtenu selon :

$$Sta = \begin{cases} ChargeStatus & if\ \left(PowS - PowL\right) > TH1 \\ DisChargeStatus & if\ \left(PowS - PowL\right) < TH0 \\ HoldStatus & if\ \ TH0 \le \left(PowS - PowL\right) \le TH1 \end{cases}$$

où *Sta* représente le signal d'indication de l'état actuel du travail, *ChargeStatus* représente le signal d'indication de l'état de charge, *DisChargeStatus* représente le signal d'indication de l'état de décharge, *HoldStatus* représente le signal d'indication de l'état de maintien, *TH*1 représente la première valeur seuil prédéfinie, et *TH*0 représente la deuxième valeur seuil prédéfinie ;
dans lequel le dispositif comprend en outre
un module d'entraînement (76) configuré pour entraîner l'amplificateur de puissance GaN avec des signaux monotons et/ou multitons sous différents voltages, températures et conditions de puissance afin d'obtenir un paramètre caractéristique de la mémoire à long terme sous différents voltages, températures et conditions de puissance, le paramètre caractéristique de la mémoire à long terme sous différents voltages, températures et conditions de puissance étant une fonction multidimensionnelle ; et former la table de recherche matricielle prédéfinie en fonction du paramètre caractéristique de la mémoire à long terme sous différents voltages, températures et conditions de puissance ;
le module d'acquisition (71) est configuré pour acquérir la puissance à court terme et la puissance à long terme du signal en bande de base, respectivement, selon les formules suivantes,

$$\text{PowS(n)} = \begin{cases} \frac{1}{N}\sum_{n-N+1}^{n}|x(i)|^2 & \text{or} \\ \lambda_S \text{PowS}(n-1) + (1-\lambda_S)|x(n)|^2 \end{cases},$$

$$\text{PowL(n)} = \begin{cases} \frac{1}{M}\sum_{n-M+1}^{n}|x(i)|^2 & \text{or} \\ \lambda_L \text{PowL}(n-1) + (1-\lambda_L)|x(n)|^2 \end{cases},$$

où *PowS*(*n*) est la puissance à court terme, *PowL*(*n*) est la puissance à long terme, *n* est un numéro d'échantillonnage du signal en bande de base, *x*(*i*) est le signal en bande de base, *N* est une longueur de fenêtre à court terme, *M* est une longueur de fenêtre à long terme, et $\lambda_S$ et $\lambda_L$ sont des facteurs de mémoire.

**3.** Appareil pour compenser l'effet mémoire à long terme d'un amplificateur de puissance GaN, dans lequel l'appareil comprend : une interface, un bus, une mémoire et un processeur, l'interface, la mémoire et le processeur sont connectés par le bus, la mémoire est configurée pour stocker un programme exécutable comprenant des instructions pour amener le processeur à exécuter les étapes du procédé de la revendication 1.

**4.** Médium de stockage lisible par ordinateur sur lequel est stocké le programme exécutable de la revendication 3.

Acquire a short-term power and a long-term power of a baseband signal — 101

Obtain a current work status indication signal according to the short-term power, the long-term power, and a preset threshold range — 102

Obtain an index address according to the current work status indication signal and parameter information — 103

Obtain, from a preset matrix lookup table, a function value corresponding to the index address — 104

Compensate for a delayed baseband signal according to the function value to obtain a compensated baseband signal — 105

FIG. 1

Conduct training with single-tone and/or multi-tone signals under different voltages, temperatures and power conditions to obtain a long-term memory characteristic parameter under different voltages, temperatures and power conditions — 201

Form the preset matrix lookup table according to the long-term memory characteristic parameter under different voltages, temperatures and power conditions — 202

Delay a baseband signal to obtain a delayed baseband signal — 203

Acquire a short-term power and a long-term power of the baseband signal — 204

Obtain a current work status indication signal according to the short-term power, the long-term power, and a preset threshold range — 205

Obtain an index address according to the current work status indication signal and parameter information — 206

Obtain, from the preset matrix lookup table, a function value corresponding to the index address — 207

Multiply the function value by the delayed baseband signal to obtain a compensated baseband signal — 208

FIG. 2

FIG. 3

FIG. 4

FIG. 5

Compensated LTE
baseband signal

| LTE baseband signal input module | → | CFR/DPD module | → | Long-term memory effect compension module | → | DAC module | → | Radio frequency channel | → | High-efficiency power amplification module | |

FIG. 6

07

Device for compensating for
long-term memory effect

| 71 Acquisition module | → | 72 First processing module | → | 73 Second processing module | → | 74 Search module | → | 75 Compensation module |

76
Training module

FIG. 7

08

Apparatus for compensating
for long-term memory effect

81

Interface

83

Memory

82

Bus

Processor

84

FIG. 8

## REFERENCES CITED IN THE DESCRIPTION

### Patent documents cited in the description

- US 9866269 B1

### Non-patent literature cited in the description

- *New Trends for the Nonlinear Measurement and Modeling of High-Power RF Transistors and Amplifiers With Memory Effects*